# FASCICULE DE BREVET EUROPEEN

(11) **EP 4 388 331 B1**
(45) Date de publication et mention de la délivrance du brevet: **30.07.2025**
(21) Numéro de dépôt: 22741335.8
(22) Date de dépôt: 14.06.2022
(51) Int. Cl.: G01R 31/385, G01R 31/327, B60L 3/04, G01R 31/3835, G01R 31/389

(54) **SUPERVISION DE LA RÉALISATION DE TESTS DE LA BATTERIE DE SERVITUDE D'UN VÉHICULE**
ÜBERWACHUNG DER DURCHFÜHRUNG VON TESTS AN EINEM NIEDERSPANNUNGSAKKUMULATOR EINES FAHRZEUGS
MONITORING THE PERFORMANCE OF TESTS ON A LOW-VOLTAGE RECHARGEABLE BATTERY OF A VEHICLE

(30) Priorité: 20.08.2021 FR 2108798
(43) Date de publication de la demande: 26.06.2024
(73) Titulaire: Stellantis Auto SAS, 78300 Poissy (FR)
(72) Inventeur: BOTCHON, Yannick, 92160 Antony (FR)
(74) Mandataire: PSIP
(86) Numéro de dépôt international: PCT/FR2022/051135
(87) Numéro de publication internationale: WO 2023/021247

(56) Documents cités:
- US-A1- 2018 364 311
- US-B2- 7 193 392

## Description

### Domaine technique de l'invention

L'invention concerne les véhicules comprenant un réseau de bord alimenté en énergie électrique par une batterie de servitude et un convertisseur, et plus précisément la supervision de tests de la batterie de servitude.

### Etat de la technique

Comme le sait l'homme de l'art, certains véhicules, éventuellement de type automobile, comprennent un réseau de bord qui est alimenté en énergie électrique par une batterie de servitude et un convertisseur. Ce dernier peut être de type courant continu/courant continu (ou DC/DC) et peut être associé à une batterie principale de type basse, moyenne ou haute tension et chargée d'alimenter en énergie électrique au moins une machine motrice électrique du groupe motopropulseur (ou GMP) du véhicule.

Dans ce qui suit et ce qui précède, on entend par « batterie de servitude » une batterie rechargeable, par exemple par le convertisseur, et de type très basse tension (typiquement 12 V, 24 V ou 48 V).

Par ailleurs, dans ce qui suit et ce qui précède, on entend par « réseau de bord » un réseau d'alimentation électrique auquel sont couplés (ou connectés) des équipements (ou organes) électriques (ou électroniques) consommant de l'énergie électrique et étant « non prioritaire(s) » pour l'un au moins d'entre eux et « sécuritaire(s) » (et donc prioritaire(s)) pour au moins un autre d'entre eux.

De plus, dans ce qui suit et ce qui précède, on entend par « équipement (ou organe) sécuritaire » un équipement (ou organe) assurant au moins une fonction dite « sécuritaire » du fait qu'elle concerne la sécurité des passagers d'un véhicule, et donc devant être alimenté en énergie électrique de façon prioritaire. C'est le cas, par exemple, de la direction assistée électrique, ou d'un dispositif de freinage électrique (frein de service, frein de secours, système d'aide au freinage ou anti-patinage, par exemple), ou encore d'un dispositif de contrôle de trajectoire.

Dans certaines situations de vie d'un véhicule, comme par exemple lors de manœuvres dites d'urgence (telles que des freinages d'urgence ou des évitements), il est indispensable que les équipements (ou organes) sécuritaires participant à ces manœuvres soient alimentés avec un niveau de puissance électrique qui garantit leur fonctionnement, ainsi que leur niveau de performance attendu.

Ce sont la batterie de servitude et le convertisseur qui sont responsables de la fourniture de ce niveau de puissance électrique aux équipements sécuritaires concernés à l'instant considéré, mais aussi, en parallèle, du niveau de puissance électrique nécessaire au fonctionnement des autres organes non sécuritaires utilisés à cet instant considéré. En cas d'incapacité à fournir la puissance électrique nécessaire à tous les organes électriques concernés à l'instant considéré, un écroulement de la tension pourrait survenir aux bornes du réseau de bord et donc des équipements électriques sécuritaires, ce qui ne permettrait pas à ces derniers de fonctionner correctement (c'est-à-dire avec un niveau de performance suffisant), et donc pourrait mettre en danger les passagers du véhicule et/ou ce dernier et/ou des personnes situées dans l'environnement de ce véhicule.

Lorsque le véhicule comprend à la fois une batterie de servitude et une batterie principale, c'est la batterie principale qui est principalement sollicitée pour alimenter le réseau de bord après conversion par le convertisseur. La batterie de servitude fournit de l'énergie électrique pour démarrer une éventuelle machine motrice thermique du GMP, et assure un complément d'alimentation électrique permettant d'éviter l'écroulement du réseau de bord en cas de forte consommation énergétique transitoire. Mais, lorsque le convertisseur est défaillant, c'est la batterie de servitude qui doit fournir intégralement l'énergie électrique au réseau de bord en garantissant des niveaux de tension minima aux organes sécuritaires.

Il est donc indispensable que la batterie de servitude soit fréquemment testée indépendamment du convertisseur pour déterminer son état en cours, et plus précisément sa capacité à fournir les niveaux de tension minima précités. Il a donc été proposé d'équiper le véhicule d'un dispositif d'isolement propre à isoler la batterie de servitude du convertisseur (mais aussi à coupler ces derniers), en cas de besoin et notamment lorsqu'un dispositif de test doit tester la batterie de servitude.

Un test consiste à solliciter la batterie de servitude, par exemple au moyen d'un ou plusieurs appels de courant successifs, afin d'évaluer des paramètres de la batterie de servitude tels que sa résistance interne et sa tension minimale atteinte.

Actuellement, lorsqu'un test est demandé par un calculateur du véhicule, on ordonne au dispositif d'isolement d'isoler la batterie de servitude du convertisseur, puis on ordonne au dispositif de test de réaliser ce test. Cependant, il peut arriver que le dispositif d'isolement soit dans l'impossibilité d'assurer une isolation totale de la batterie de servitude pendant un test, par exemple du fait d'une fuite de courant au niveau d'un interrupteur, et dans ce cas le test est faussé. Il peut alors être décidé en interne d'utiliser la batterie de servitude pour pallier une défaillance du convertisseur alors même que dans la réalité cette batterie de servitude n'est pas en mesure de fournir les niveaux de tension minima précités, ce qui peut s'avérer (très) dangereux. Il peut aussi arriver que le dispositif d'isolement soit dans l'impossibilité d'isoler, même partiellement, la batterie de servitude du convertisseur, ce qui peut fausser les résultats du test.

US 2018/364311 A1 concerne la mesure d'une caractéristique de batteries.

US 7 193 392 B2 divulgue la détermination et l'équilibrage de l'état de charge entre des unités de stockage d'énergie électrique connectées en série.

L'invention a donc notamment pour but d'améliorer la situation par une supervision des tests de la batterie de servitude.

### Présentation de l'invention

Elle propose notamment à cet effet un procédé de supervision destiné à être mis en œuvre dans un véhicule comprenant un réseau de bord alimenté en énergie électrique par une batterie de servitude et un convertisseur, un dispositif d'isolement propre à isoler ces derniers l'un de l'autre ou à coupler ces derniers, et un dispositif de test propre à réaliser un test de la batterie de servitude pour déterminer une tension minimale aux bornes de cette dernière et une résistance interne de cette batterie de servitude.

Ce procédé de supervision se caractérise par le fait qu'il comprend une étape dans laquelle, en cas de demande de test, on détermine si le dispositif d'isolement est propre à assurer l'isolement, et dans l'affirmative on ordonne cet isolement puis on ordonne la réalisation du test.

Ainsi, on est certain, lorsque la capacité du dispositif d'isolement à assurer l'isolement total est effective, que le résultat du test à réaliser ne sera pas faussé et donc pourra être utilisé par le calculateur qui a demandé ce test.

Le procédé de supervision selon l'invention peut comporter d'autres caractéristiques qui peuvent être prises séparément ou en combinaison, et notamment :
- dans son étape on peut aussi déterminer si le dispositif de test est propre à réaliser le test demandé, et dans l'affirmative et lorsque le dispositif d'isolement est propre à assurer l'isolement on peut ordonner ce dernier puis on peut ordonner la réalisation du test ;
- en présence de la première option, dans son étape, lorsque le dispositif d'isolement est propre à assurer l'isolement et que le dispositif de test est propre à réaliser le test, on peut déterminer si le dispositif de test est déjà en train de réaliser un test, et dans la négative on peut ordonner l'isolement puis on peut ordonner la réalisation du test ;
- dans son étape, en cas de besoin de couplage entre le convertisseur et la batterie de servitude pendant la réalisation du test, on peut ordonner ce couplage et on peut ordonner une interruption du test ;
- dans son étape, à la fin de la réalisation du test, on peut déterminer un état de la batterie de servitude BS en fonction des tension minimale et résistance interne déterminées, puis on peut déterminer une information de fiabilité du test en fonction d'au moins les tension minimale et résistance interne ;
- dans son étape on peut réaliser le test en provoquant au moins deux appels de courant prédéfinis par la batterie de servitude, pendant chacun desquels une tension minimale intermédiaire aux bornes de la batterie de servitude et une résistance interne intermédiaire de cette dernière sont déterminées, et on peut déterminer la tension minimale à partir de ces tensions minimales intermédiaires déterminées et la résistance interne à partir de ces résistances internes intermédiaires déterminées.

L'invention propose également un produit programme d'ordinateur comprenant un jeu d'instructions qui, lorsqu'il est exécuté par des moyens de traitement, est propre à mettre en œuvre un procédé de supervision du type de celui présenté ci-avant pour superviser la réalisation de tests d'une batterie de servitude équipant un véhicule comprenant un réseau de bord alimenté en énergie électrique par cette batterie de servitude et un convertisseur, un dispositif d'isolement propre à isoler ces derniers l'un de l'autre ou à coupler ces derniers, et un dispositif de test propre à réaliser les tests de la batterie de servitude pour déterminer une tension minimale aux bornes de cette dernière et une résistance interne de la batterie de servitude.

L'invention propose également un dispositif de supervision destiné à équiper un véhicule comprenant un réseau de bord alimenté en énergie électrique par une batterie de servitude et un convertisseur, un dispositif d'isolement propre à isoler ces derniers l'un de l'autre ou à coupler ces derniers, et un dispositif de test propre à réaliser un test de la batterie de servitude pour déterminer une tension minimale aux bornes de cette dernière et une résistance interne de la batterie de servitude.

Ce dispositif de supervision se caractérise par le fait qu'il comprend au moins un processeur et au moins une mémoire agencés pour effectuer les opérations consistant, en cas de demande de test, à déterminer si le dispositif d'isolement est propre à assurer l'isolement, et dans l'affirmative à ordonner cet isolement puis à ordonner la réalisation du test.

L'invention propose également un véhicule, éventuellement de type automobile, et comprenant un réseau de bord alimenté en énergie électrique par une batterie de servitude et un convertisseur, un dispositif d'isolement propre à isoler ces derniers l'un de l'autre ou à coupler ces derniers, un dispositif de test propre à réaliser un test de la batterie de servitude pour déterminer une tension minimale aux bornes de cette dernière et une résistance interne de la batterie de servitude, ainsi qu'un dispositif de supervision du type de celui présenté ci-avant.

### Brève description des figures

D'autres caractéristiques et avantages de l'invention apparaîtront à l'examen de la description détaillée ci-après, et des dessins annexés, sur lesquels :
[Fig. 1] illustre schématiquement et fonctionnellement un exemple de réalisation d'un véhicule comprenant un réseau de bord, alimenté par une batterie de servitude et un convertisseur, un dispositif d'isolement, un dispositif de test, et un dispositif de supervision selon l'invention,
[Fig. 2] illustre schématiquement et fonctionnellement un exemple de réalisation d'un dispositif de supervision selon l'invention, et
[Fig. 3] illustre schématiquement un exemple d'algorithme mettant en œuvre un procédé de supervision selon l'invention.

### Description détaillée de l'invention

L'invention a notamment pour but de proposer un procédé de supervision, et un dispositif de supervision DS associé, destinés à permettre la supervision de la réalisation de tests d'une batterie de servitude BS équipant un véhicule V comprenant un réseau de bord RB alimenté en énergie électrique par cette batterie de servitude BS et un convertisseur CV.

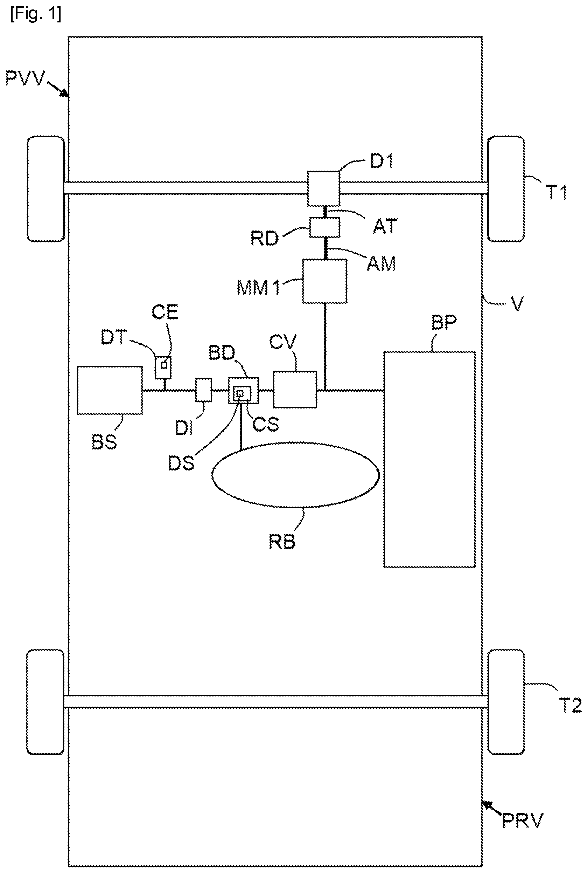

Dans ce qui suit, on considère, à titre d'exemple non limitatif, que le véhicule V est de type automobile. Il s'agit par exemple d'une voiture, comme illustré sur la figure 1. Mais l'invention n'est pas limitée à ce type de véhicule. Elle concerne en effet tout type de véhicule comprenant un réseau de bord alimenté en énergie électrique par une batterie de servitude et un convertisseur. Ainsi, elle concerne, par exemple, les véhicules terrestres (véhicules utilitaires, camping-cars, minibus, cars, camions, motocyclettes, engins de voirie, engins de chantier, engins agricoles, engins de loisir (motoneige, kart), et engins à chenille(s), par exemple), les bateaux et les aéronefs.

Par ailleurs, on considère dans ce qui suit, à titre d'exemple non limitatif, que le véhicule V comprend un groupe motopropulseur (ou GMP) de type tout électrique (et donc dont la motricité est assurée exclusivement par au moins une machine motrice électrique). Mais le GMP pourrait être de type hybride (thermique et électrique).

On a schématiquement représenté sur la figure 1 un véhicule V comprenant une chaîne de transmission à GMP électrique, un réseau de bord RB, une batterie de servitude BS, un convertisseur CV, un dispositif d'isolement DI, un dispositif de test DT, et un dispositif de supervision DS selon l'invention.

Le réseau de bord RB est un réseau d'alimentation électrique auquel sont couplés (ou connectés) des équipements (ou organes) électriques (ou électroniques) qui consomment de l'énergie électrique et qui pour certains d'entre eux sont « non prioritaires » et pour certains autres sont « sécuritaires » (et donc prioritaires). Par exemple, un équipement (ou organe) sécuritaire peut être une direction assistée électrique, ou un dispositif de freinage électrique (frein de service, frein de secours, système d'aide au freinage ou anti-patinage, par exemple), ou encore un dispositif de contrôle de trajectoire. Egalement par exemple, un équipement (ou organe) non sécuritaire peut être une installation de chauffage/climatisation ou un dispositif de chauffage de siège ou un dispositif de massage de siège.

La batterie de servitude BS est chargée de fournir de l'énergie électrique au réseau de bord RB, en complément de celle fournie par le convertisseur CV (alimenté par une batterie principale BP décrite plus loin). Par exemple, cette batterie de servitude BS peut être agencée sous la forme d'une batterie de type très basse tension (typiquement 12 V, 24 V ou 48 V). Elle est ici rechargeable au moins par le convertisseur CV du véhicule V. On considère dans ce qui suit, à titre d'exemple non limitatif, que la batterie de servitude BS est de type Lithium-ion 12 V.

La chaîne de transmission a un GMP qui est, ici, purement électrique et donc qui comprend, notamment, une machine motrice MM1 électrique, un arbre moteur AM, une batterie principale BP et un arbre de transmission AT. On entend ici par « machine motrice électrique » une machine électrique agencée de manière à fournir ou récupérer du couple pour déplacer le véhicule V.

La machine motrice MM1 (ici un moteur électrique) est couplée à la batterie principale BP, afin d'être alimentée en énergie électrique, ainsi qu'éventuellement d'alimenter cette batterie principale BP en énergie électrique. Elle est couplée à l'arbre moteur AM, pour lui fournir du couple par entraînement en rotation. Cet arbre moteur AM est ici couplé à un réducteur RD qui est aussi couplé à l'arbre de transmission AT, lui-même couplé à un premier train T1 (ici de roues), de préférence via un différentiel D1.

Ce premier train T1 est ici situé dans la partie avant PVV du véhicule V. Mais dans une variante ce premier train T1 pourrait être celui qui est ici référencé T2 et qui est situé dans la partie arrière PRV du véhicule V.

Par exemple, la batterie principale BP peut être de type basse tension (typiquement 400 V à titre illustratif). Mais elle pourrait être de type moyenne tension ou haute tension.

La machine motrice MM1 est, ici, aussi couplée au convertisseur CV qui est aussi couplé indirectement à la batterie de servitude BS, notamment pour la recharger avec de l'énergie électrique issue de la batterie principale BP et convertie.

Ce convertisseur CV est de type courant continu/courant continu (ou DC/DC), à titre d'exemple. Il est ici aussi chargé d'alimenter le réseau de bord RB en énergie électrique issue de la batterie principale BP et convertie, en plus d'assurer la recharge de la batterie de servitude BS.

On notera que dans l'exemple illustré non limitativement sur la figure 1 le véhicule V comprend un boîtier de distribution BD auquel sont couplés la batterie de servitude BS, le convertisseur CV et le réseau de bord RB. Ce boîtier de distribution BD est chargé de distribuer dans le réseau de bord RB l'énergie électrique stockée dans la batterie de servitude BS ou produite par le convertisseur CV, pour l'alimentation des organes (ou équipements) électriques en fonction de demandes d'alimentation reçues. La supervision de la distribution de cette énergie électrique peut être assurée par un calculateur de supervision CS. Dans l'exemple illustré non limitativement sur la figure 1, le calculateur de supervision CS fait partie du boîtier de distribution BD. Mais dans une variante de réalisation (non illustrée) le calculateur de supervision CS pourrait ne pas faire partie du boîtier de distribution BD.

Le dispositif de test DT est propre à réaliser un test de la batterie de servitude BS pour déterminer une tension minimale aux bornes de cette dernière (BS) et une résistance interne de la batterie de servitude BS. Par exemple, il peut comprendre une charge électrique CE dédiée et montée en série avec au moins un interrupteur, à base de MOSFET(s) et destiné à isoler (dans son état ouvert) la batterie de servitude BS de la charge électrique CE ou à coupler (dans son état fermé) la batterie de servitude BS à la charge électrique CE pour appeler un courant de décharge prédéfini (par exemple de 60 A).

Le dispositif d'isolement DI est agencé de manière à isoler l'un de l'autre la batterie de servitude BS et le convertisseur CV ou à coupler ces derniers (BS, CV), selon les besoins. Il peut notamment être placé dans un état ouvert dans lequel il est censé isoler la batterie de servitude BS du convertisseur CV, par exemple lors d'un test de la batterie de servitude BS destiné à déterminer au moins sa résistance interne et sa tension minimale atteinte, et dans un état fermé dans lequel il couple la batterie de servitude BS au convertisseur CV.

Par exemple, le dispositif d'isolement DI peut comprendre au moins un interrupteur à base de MOSFET(s) destiné à isoler la batterie de servitude BS du convertisseur CV (dans son état ouvert) ou à coupler la batterie de servitude BS au convertisseur CV (dans son état fermé).

Comme évoqué plus haut, l'invention propose notamment un procédé de supervision destiné à permettre la supervision de la réalisation des tests de la batterie de servitude BS.

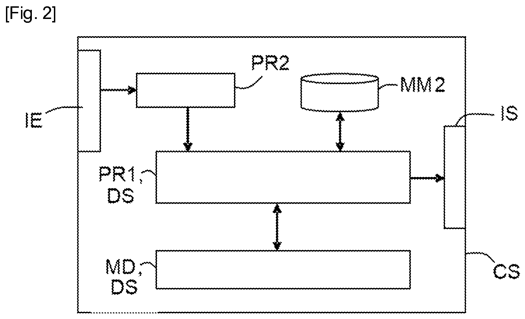

Ce procédé (de supervision) peut être mis en œuvre au moins en partie par un dispositif de supervision DS du type de celui illustré sur la figure 2 et comprenant au moins un processeur PR1 et au moins une mémoire MD qui sont agencés pour effectuer des opérations lorsqu'il a été réveillé, par exemple par le calculateur de supervision CS lorsque ce dernier (CS) veut obtenir un diagnostic de l'état de la batterie de servitude BS, ou éventuellement dès que l'électronique embarquée est réveillée par un calculateur maître du véhicule.

On notera que dans l'exemple illustré non limitativement sur la figure 1, le dispositif de supervision DS fait partie du calculateur de supervision CS. Mais il pourrait s'agir d'un équipement couplé au calculateur de supervision CS. D'une manière générale, le dispositif de supervision DS est réalisé sous la forme d'une combinaison de circuits ou composants électriques ou électroniques (ou « hardware ») et de modules logiciels (ou « software »).

Le processeur PR1 peut, par exemple, être un processeur de signal numérique (ou DSP (« Digital Signal Processor »)). Ce processeur PR1 peut comprendre des circuits intégrés (ou imprimés), ou bien plusieurs circuits intégrés (ou imprimés) reliés par des connections filaires ou non filaires. On entend par circuit intégré (ou imprimé) tout type de dispositif apte à effectuer au moins une opération électrique ou électronique. Ainsi, il peut, par exemple, s'agir d'un microcontrôleur.

La mémoire MD est vive afin de stocker des instructions pour la mise en œuvre par le processeur PR1 d'une partie au moins du procédé de supervision décrit ci-dessous (et donc de ses fonctionnalités).

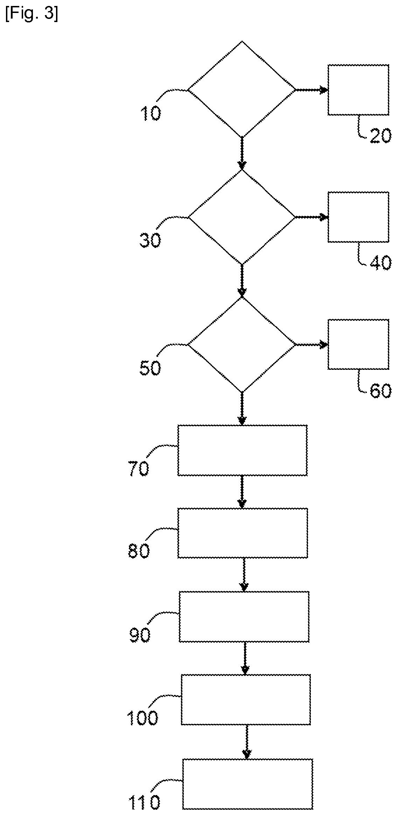

Comme illustré non limitativement sur la figure 3, le procédé (de supervision), selon l'invention, comprend une étape 10-110.

Cette étape 10-110 comprend tout d'abord une sous-étape 10 dans laquelle, en cas de demande de test, on (le dispositif de supervision DS) détermine si le dispositif d'isolement DI est propre à assurer l'isolement (total).

Par exemple, cette détermination peut se faire en testant le fonctionnement du dispositif d'isolement DI, c'est-à-dire en vérifiant s'il peut passer de son état fermé à son état totalement ouvert, et inversement. On notera que ce test de fonctionnement ne se fait pas nécessairement dans la sous-étape 10. Il peut en effet être réalisé antérieurement, par exemple juste après le (chaque) réveil du véhicule V, et dans ce cas la détermination consiste à obtenir le résultat du dernier test de fonctionnement effectué.

Dans la négative (dispositif d'isolement DI ne pouvant pas assurer l'isolement total) on (le dispositif de supervision DS) signale dans une sous-étape 20 au calculateur qui a demandé le test (par exemple le calculateur de supervision CS) que ce test ne peut pas être réalisé. Le procédé de supervision prend alors fin.

Dans l'affirmative (dispositif d'isolement DI pouvant assurer l'isolement total), l'étape 10-110 comprend une sous-étape 70 dans laquelle on (le dispositif de supervision DS) ordonne l'isolement par le dispositif d'isolement DI (placement dans l'état ouvert), puis une sous-étape 80 dans laquelle on (le dispositif de supervision DS) ordonne la réalisation du test demandé par le dispositif de test DT. Le test est alors réalisé dans une sous-étape 90 par le dispositif de test DT.

Grâce à cette vérification de la capacité du dispositif d'isolement DI à assurer l'isolement total, on est certain que lorsque cette capacité est effective le résultat du test à réaliser ne sera pas faussé et donc pourra être utilisé sans risque par le calculateur qui a demandé ce test.

On comprendra que ce sont les processeur PR1 et mémoire MD qui sont agencés pour effectuer les opérations consistant, en cas de demande de test, à déterminer si le dispositif d'isolement DI est propre à assurer l'isolement, et dans l'affirmative à ordonner cet isolement puis à ordonner la réalisation du test demandé.

Par exemple, et comme illustré non limitativement sur la figure 3, l'étape 10-110 peut comprendre une sous-étape 30 dans laquelle on (le dispositif de supervision DS) peut déterminer si le dispositif de test DT est propre à réaliser le test demandé.

Par exemple, cette détermination peut se faire en testant le fonctionnement du dispositif de test DT, c'est-à-dire en vérifiant s'il peut passer de son état totalement ouvert à son état fermé, et inversement. On notera que ce test de fonctionnement ne se fait pas nécessairement dans la sous-étape 30. Il peut en effet être réalisé antérieurement, par exemple juste après le (chaque) réveil du véhicule V, et dans ce cas la détermination consiste à obtenir le résultat du dernier test de fonctionnement effectué. Lorsque ce test de fonctionnement se fait dans la sous-étape 30 il est préférable de placer préalablement le dispositif d'isolement DI dans son état ouvert pour isoler la batterie de servitude BS et ainsi éviter qu'elle se décharge lors d'une alimentation du réseau de bord RB, ce qui modifierait son état de charge.

Dans la négative (dispositif de test DT ne pouvant pas réaliser le test), on (le dispositif de supervision DS) signale dans une sous-étape 40 au calculateur qui a demandé le test (par exemple le calculateur de supervision CS) que ce test ne peut pas être réalisé. Le procédé de supervision prend alors fin.

Dans l'affirmative (dispositif de test DT pouvant réaliser le test) et lorsqu'en outre le dispositif d'isolement DI est propre à assurer l'isolement, on (le dispositif de supervision DS) ordonne l'isolement (sous-étape 70), puis on (le dispositif de supervision DS) ordonne la réalisation du test (sous-étape 80).

Grâce à cette vérification complémentaire de la capacité du dispositif de test DT à réaliser un test avant d'ordonner la réalisation de ce dernier, on évite une perte de temps inutile lors de la réalisation d'un test irréalisable, ce qui permet au calculateur qui a demandé ce test de prendre sa décision plus rapidement (quasi immédiatement).

Egalement par exemple, et comme illustré non limitativement sur la figure 3, l'étape 10-110 peut comprendre une sous-étape 50 dans laquelle, lorsque le dispositif d'isolement DI est propre à assurer l'isolement et que le dispositif de test DT est propre à réaliser le test demandé, on (le dispositif de supervision DS) peut déterminer si le dispositif de test DT est déjà en train de réaliser un test.

Dans l'affirmative (dispositif de test DT déjà en train de réaliser un test), on (le dispositif de supervision DS) signale dans une sous-étape 60 au calculateur qui a demandé le test (par exemple le calculateur de supervision CS) que ce test ne peut pas être réalisé car un autre test est en cours de réalisation. Le procédé de supervision prend alors fin.

Dans la négative (dispositif de test DT n'étant pas en train de réaliser un test), on (le dispositif de supervision DS) ordonne l'isolement (sous-étape 70), puis on (le dispositif de supervision DS) ordonne la réalisation du test (sous-étape 80).

On notera que dans l'étape 10-110 il peut survenir un besoin de couplage entre le convertisseur CV et la batterie de servitude BS pendant la réalisation d'un test (par exemple en cas de défaillance survenue dans le convertisseur CV ou la batterie principale BP ou la batterie de surveillance BS, ou bien d'une manœuvre sécuritaire en cours ou à réaliser et nécessitant l'interruption immédiate du test). Dans ce cas, on (le dispositif de supervision DS) peut ordonner dans une sous-étape 100 le couplage de la batterie de surveillance BS au convertisseur CV par le dispositif d'isolement DI (passage dans son état fermé), et on (le dispositif de supervision DS) peut ordonner dans une sous-étape 110 une interruption du test par le dispositif de test DT (passage dans son état ouvert).

On notera également que dans la sous-étape 90 de l'étape 10-110 le dispositif de test DT peut réaliser le test en provoquant au moins deux appels de courant prédéfinis par la batterie de servitude BS, par exemple en se plaçant dans son état fermé pour mettre en série la charge électrique CE et la batterie de servitude BS. Dans ce cas, pendant chaque appel de courant le dispositif de test DT détermine une tension minimale intermédiaire aux bornes de la batterie de servitude BS et une résistance interne intermédiaire de cette dernière (BS). Ensuite, le dispositif de test DT peut déterminer la tension minimale à partir de ces tensions minimales intermédiaires déterminées et la résistance interne à partir de ces résistances internes intermédiaires déterminées.

Par exemple, le nombre d'appels de courant de chaque test peut être égal à trois. Mais ce nombre peut prendre n'importe quelle valeur supérieure ou égale à deux.

Egalement par exemple, chaque appel de courant d'un test peut être d'au moins 60 A (il dépend de la charge électrique CE). Ainsi, il peut, par exemple, être égal à 100 A. Par ailleurs, chaque appel de courant d'un test peut, par exemple, avoir une durée de 200 ms, et peut être effectué selon une période qui est, par exemple, égale à 400 ms (200 ms d'appel de courant par placement du dispositif de test DT dans son état fermé, puis 200 ms de « repos » (sans appel de courant) par placement du dispositif de test DT dans son état ouvert). Toutes les durées qui précèdent sont données à titre d'exemple illustratif et sont toutes paramétrables.

Egalement par exemple, la tension minimale déterminée pendant un test peut être égale à la moyenne des tensions minimales intermédiaires déterminées lors de chacun des appels de courant de ce test, et la résistance interne déterminée pendant un test peut être égale à la moyenne des résistances internes intermédiaires déterminées lors de chacun des appels de courant de ce test.

Les déterminations des tensions minimales intermédiaires et résistance interne intermédiaire peuvent, par exemple, être effectuées après l'expiration d'une durée paramétrable après l'apparition (ou le début) de la variation du courant sortant de la batterie de servitude BS (la dynamique de tension est plus faible que la dynamique de courant). Par exemple, cette durée paramétrable peut être choisie égale à 5 ms. De préférence, chaque détermination d'une résistance interne intermédiaire est effectuée juste après l'expiration de la durée paramétrable, tandis que chaque détermination d'une tension minimale intermédiaire est effectuée à l'expiration d'un intervalle de temps débutant juste après l'expiration de la durée paramétrable et ayant une durée strictement inférieure à la durée de l'appel de courant, et par exemple égale à 100 ms. Dans ce cas, on détermine la résistance interne intermédiaire immédiatement après la fin de la variation du courant sortant de la batterie de servitude BS (soit 5 ms ou 6 ms après le début de cette variation) et la tension minimale intermédiaire 100 ms après la fin de la variation du courant sortant de la batterie de servitude BS (soit 105 ms après le début de cette variation).

Chaque résistance interne intermédiaire peut être déduite de la variation de la tension Δu pendant la variation de courant Δi et de cette variation du courant Δi déterminée (r = Δu/Δi).

De préférence, pendant chaque appel de courant les déterminations de la tension minimale intermédiaire aux bornes de la batterie de servitude BS et de la résistance interne intermédiaire de cette dernière (BS) ne se font que lorsqu'au moins une condition prédéfinie est satisfaite.

Une première condition peut, par exemple, consister à avoir un courant sortant de la batterie de servitude BS qui est inférieure à un seuil (paramétrable) Par exemple, ce seuil peut être choisi égal à -50 A.

Une deuxième condition peut, par exemple, consister à n'effectuer les déterminations précitées que lorsque le courant sortant de la batterie de servitude BS croit d'une valeur qui est supérieur au seuil précité pendant une durée paramétrable (par exemple égale à 5 ms) qui débute en même temps que débute l'appel de courant.

Une troisième condition peut, par exemple, consister en l'absence de signalement de défaillance par les capteurs de courant/tension pendant leurs mesures.

La satisfaction de ces conditions permet de remplir des exigences minimales en termes de représentativité du profil de courant et de précision du calcul de la résistance interne.

Lorsque l'une au moins des conditions précitées n'est pas satisfaite, les tensions minimales intermédiaires et résistance interne intermédiaire ne sont pas déterminées.

On notera également que dans la sous-étape 90 de l'étape 10-110, à la fin de la réalisation d'un test (complet), on (le dispositif de supervision DS) peut déterminer un état de la batterie de servitude BS en fonction des tension minimale et résistance interne déterminées, puis on (le dispositif de supervision DS) peut déterminer une information de fiabilité du test en fonction d'au moins les tension minimale et résistance interne.

Cette information de fiabilité est de nature à renforcer l'intérêt qu'offre la connaissance de l'état en cours de la batterie de servitude BS, puisqu'il garantit que cet état est conforme à la réalité à l'instant considéré.

Par exemple, une information de fiabilité est représentative d'un test fiable de façon certaine lorsque les résistance interne et tension minimale déterminées sont considérées comme fiables en raison de leurs valeurs normales.

Egalement par exemple, une information de fiabilité représentative d'un test non fiable peut résulter du fait que les résistance interne et tension minimale déterminées sont considérées comme non fiables en raison de leurs valeurs anormales, ou de conditions non optimales pour réussir le test, ou encore d'une interruption du test requise par un calculateur du véhicule V (éventuellement le calculateur maître).

L'information de fiabilité du test est transmise avec l'état de la batterie de servitude BS au calculateur qui a demandé le test (par exemple le calculateur de supervision CS).

On notera également, comme illustré non limitativement sur la figure 2, que le calculateur de supervision CS (ou l'éventuel calculateur du dispositif de supervision DS) peut aussi comprendre, en complément des mémoire vive MD et processeur PR1, une mémoire de masse MM2, notamment pour le stockage de l'état de la batterie de servitude BS et de l'éventuelle information de fiabilité et de données intermédiaires intervenant dans tous ses calculs et traitements. Par ailleurs, ce calculateur de supervision CS (ou l'éventuel calculateur du dispositif de supervision DS) peut aussi comprendre une interface d'entrée IE pour la réception d'au moins le message signalant si le dispositif d'isolement DI est propre (ou non) à assurer l'isolement (total), l'éventuel message signalant si le dispositif de test DT est propre (ou non) à réaliser un test, et l'éventuel message signalant si le dispositif de test DT est (ou non) déjà en train de réaliser un test, l'état de la batterie de servitude BS et l'éventuelle information de fiabilité pour les utiliser dans des calculs ou traitements, éventuellement après les avoir mis en forme et/ou démodulés et/ou amplifiés, de façon connue en soi, au moyen d'un processeur de signal numérique PR2. De plus, ce calculateur de supervision CS (ou l'éventuel calculateur du dispositif de supervision DS) peut aussi comprendre une interface de sortie IS, notamment pour délivrer les messages ou ordres d'isolement, de couplage ou de réalisation de test, et les requêtes d'obtention de la capacité du dispositif d'isolement DI à assurer l'isolement (total), les éventuelles requêtes d'obtention de la capacité du dispositif de test DT à réaliser un test.

On notera également que l'invention propose aussi un produit programme d'ordinateur (ou programme informatique) comprenant un jeu d'instructions qui, lorsqu'il est exécuté par des moyens de traitement de type circuits électroniques (ou hardware), comme par exemple le processeur PR1, est propre à mettre en œuvre le procédé de supervision décrit ci-avant pour superviser la réalisation des tests de la batterie de servitude BS.

## Revendications

1. Procédé de supervision pour un véhicule (V) comprenant un réseau de bord (RB) alimenté en énergie électrique par une batterie de servitude (BS) et un convertisseur (CV), un dispositif d'isolement (DI) propre à isoler ces derniers (BS, CV) l'un de l'autre ou à coupler ces derniers (BS, CV), et un dispositif de test (DT) propre à réaliser un test de ladite batterie de servitude (BS) pour déterminer une tension minimale aux bornes de cette dernière (BS) et une résistance interne de ladite batterie de servitude (BS), **caractérisé en ce qu'**il comprend une étape (10-110) dans laquelle, en cas de demande de test, on détermine si ledit dispositif d'isolement (DI) est propre à assurer l'isolement, et dans l'affirmative on ordonne ledit isolement puis on ordonne la réalisation dudit test.

2. Procédé selon la revendication 1, **caractérisé en ce que** dans ladite étape (10-110) on détermine également si ledit dispositif de test (DT) est propre à réaliser ledit test, et dans l'affirmative et lorsque ledit dispositif d'isolement (DI) est propre à assurer ledit isolement on ordonne ce dernier puis on ordonne la réalisation dudit test.

3. Procédé selon la revendication 2, **caractérisé en ce que** dans ladite étape (10-110), lorsque ledit dispositif d'isolement (DI) est propre à assurer ledit isolement et que ledit dispositif de test (DT) est propre à réaliser ledit test, on détermine si ledit dispositif de test (DT) est déjà en train de réaliser un test, et dans la négative on ordonne ledit isolement puis on ordonne ladite réalisation du test.

4. Procédé selon l'une des revendications 1 à 3, **caractérisé en ce que** dans ladite étape (10-110), en cas de besoin de couplage entre lesdits convertisseur (CV) et batterie de servitude (BS) pendant la réalisation dudit test, on ordonne ledit couplage et on ordonne une interruption dudit test.

5. Procédé selon l'une des revendications 1 à 4, **caractérisé en ce que** dans ladite étape (10-110), à la fin de la réalisation dudit test on détermine un état de ladite batterie de servitude (BS) en fonction desdites tension minimale et résistance interne déterminées, puis on détermine une information de fiabilité dudit test en fonction d'au moins lesdites tension minimale et résistance interne.

6. Procédé selon l'une des revendications 1 à 5, **caractérisé en ce que** dans ladite étape (10-110) on réalise ledit test en provoquant au moins deux appels de courant prédéfinis par ladite batterie de servitude (BS), pendant chacun desquels une tension minimale intermédiaire aux bornes de ladite batterie de servitude (BS) et une résistance interne intermédiaire de cette dernière (BS) sont déterminées, et on détermine ladite tension minimale à partir desdites tensions minimales intermédiaires déterminées et ladite résistance interne à partir desdites résistances internes intermédiaires déterminées.

7. Produit programme d'ordinateur comprenant un jeu d'instructions qui, lorsqu'il est exécuté par des moyens de traitement, est propre à mettre en œuvre le procédé de supervision selon l'une des revendications précédentes pour superviser la réalisation de tests d'une batterie de servitude (BS) équipant un véhicule (V) comprenant un réseau de bord (RB) alimenté en énergie électrique par ladite batterie de servitude (BS) et un convertisseur (CV), un dispositif d'isolement (DI) propre à isoler ces derniers (BS, CV) l'un de l'autre ou à coupler ces derniers (BS, CV), et un dispositif de test (DT) propre à réaliser lesdits tests de ladite batterie de servitude (BS) pour déterminer une tension minimale aux bornes de cette dernière (BS) et une résistance interne de ladite batterie de servitude (BS).

8. Dispositif de supervision (DS) pour un véhicule (V) comprenant un réseau de bord (RB) alimenté en énergie électrique par une batterie de servitude (BS) et un convertisseur (CV), un dispositif d'isolement (DI) propre à isoler ces derniers (BS, CV) l'un de l'autre ou à coupler ces derniers (BS, CV), et un dispositif de test (DT) propre à réaliser un test de ladite batterie de servitude (BS) pour déterminer une tension minimale aux bornes de cette dernière (BS) et une résistance interne de ladite batterie de servitude (BS), **caractérisé en ce qu'**il comprend au moins un processeur (PR1) et au moins une mémoire (MD) agencés pour effectuer les opérations consistant, en cas de demande de test, à déterminer si ledit dispositif d'isolement (DI) est propre à assurer l'isolement, et dans l'affirmative à ordonner ledit isolement puis à ordonner la réalisation dudit test.

9. Véhicule (V) comprenant un réseau de bord (RB) alimenté en énergie électrique par une batterie de servitude (BS) et un convertisseur (CV), un dispositif d'isolement (DI) propre à isoler ces derniers (BS, CV) l'un de l'autre ou à coupler ces derniers (BS, CV), et un dispositif de test (DT) propre à réaliser un test de ladite batterie de servitude (BS) pour déterminer une tension minimale aux bornes de cette dernière (BS) et une résistance interne de ladite batterie de servitude (BS), **caractérisé en ce qu'**il comprend en outre un dispositif de supervision (DS) selon la revendication 8.

10. Véhicule selon la revendication 9, **caractérisé en ce qu'**il est de type automobile.

## Patentansprüche

1. Überwachungsverfahren für ein Fahrzeug (V) , das ein Bordnetz (RB) umfasst , das von einer Servicebatterie (BS) und einem Konverter (CV) mit elektrischer Energie versorgt wird, eine Trennvorrichtung (DI), die die letzteren (BS, CV) voneinander trennen oder koppeln kann, und eine Testvorrichtung (DT), die einen Test der Servicebatterie (BS) durchführen kann, um eine Mindestspannung an den Anschlüssen der letzteren (BS) und einen Innenwiderstand der Servicebatterie (BS) zu bestimmen , **dadurch gekennzeichnet, dass** es einen Schritt (10-110) umfasst, in dem im Falle einer Testanforderung festgestellt wird , ob die Trennvorrichtung (DI) in der Lage ist, die Trennung sicherzustellen, und wenn dies der Fall ist, die Trennung angeordnet wird und anschließend die Durchführung des Tests angeordnet wird.

2. Verfahren nach Anspruch 1, **dadurch gekennzeichnet, dass** in dem Schritt (10-110) auch ermittelt wird, ob das Testgerät (DT) zur Durchführung des Tests geeignet ist, und wenn dies der Fall ist und das Isolationsgerät (DI) zur Gewährleistung der Isolierung geeignet ist, wird letzteres angefordert und anschließend die Durchführung des Tests angeordnet.

3. Verfahren nach Anspruch 2, **dadurch gekennzeichnet, dass** in dem Schritt (10-110) , wenn das Isolationsgerät (DI) geeignet ist, die Isolation sicherzustellen und das Testgerät (DT) geeignet ist, den Test durchzuführen, ermittelt wird , ob das Testgerät (DT) bereits einen Test durchführt, und wenn nicht, die Isolation angeordnet wird und anschließend die Durchführung des Tests angeordnet wird.

4. Verfahren nach einem der Ansprüche 1 bis 3, **dadurch gekennzeichnet, dass** in dem Schritt (10-110) wird im Falle der Notwendigkeit einer Kopplung zwischen dem Konverter (CV) und der Servicebatterie (BS) während der Durchführung des Tests die Kopplung angeordnet und eine Unterbrechung des Tests befohlen.

5. Verfahren nach einem der Ansprüche 1 bis 4, **dadurch gekennzeichnet, dass** in dem Schritt (10-110) wird am Ende der Durchführung des Tests ein Zustand der Servicebatterie (BS) als Funktion der ermittelten Mindestspannung und des ermittelten Innenwiderstands ermittelt, dann werden Zuverlässigkeitsinformationen des Tests als Funktion zumindest dieser Mindestspannung und des Innenwiderstands ermittelt .

6. Verfahren nach einem der Ansprüche 1 bis 5, **dadurch gekennzeichnet, dass** in dem Schritt (10-110) der Test wird durchgeführt, indem von der Servicebatterie (BS) mindestens zwei vordefinierte Stromentnahmen veranlasst werden, während derer jeweils eine minimale Zwischenspannung an den Anschlüssen der Servicebatterie (BS) und ein Zwischeninnenwiderstand der letzteren (BS) bestimmt werden, und die minimale Spannung aus den bestimmten minimalen Zwischenspannungen und der Innenwiderstand aus den bestimmten Zwischeninnenwiderständen bestimmt wird.

7. Computerprogrammprodukt, das einen Satz von Anweisungen umfasst, die, wenn sie von Verarbeitungsmitteln ausgeführt werden, in der Lage sind, das Überwachungsverfahren gemäß einem der vorhergehenden Ansprüche zu implementieren, um die Durchführung von Tests einer Servicebatterie (BS) zu überwachen, mit der ein Fahrzeug (V) ausgestattet ist, das ein von der Servicebatterie (BS) und einem Konverter (CV) mit elektrischer Energie versorgtes Bordnetz (RB) , eine Trennvorrichtung (DI), die die letzteren (BS, CV) voneinander trennen oder koppeln kann (BS, CV), und eine Testvorrichtung (DT) umfasst, die in der Lage ist, die Tests der Servicebatterie (BS) durchzuführen, um eine Mindestspannung an den Anschlüssen der letzteren (BS) und einen Innenwiderstand der Servicebatterie (BS) zu bestimmen.

8. Überwachungsgerät (DS) für ein Fahrzeug (V), das ein von einer Servicebatterie (BS) und einem Konverter (CV) mit elektrischer Energie versorgtes Bordnetz (RB) , eine Trennvorrichtung (DI), die die beiden (BS, CV) voneinander trennen oder koppeln kann, und eine Testvorrichtung (DT) umfasst, die einen Test der Servicebatterie (BS) durchführen kann, um eine Mindestspannung an den Anschlüssen der Batterie (BS) und einen Innenwiderstand der Servicebatterie (BS) zu bestimmen , **dadurch gekennzeichnet, dass** es mindestens einen Prozessor (PR1) und mindestens einen Speicher (MD) umfasst, die dazu eingerichtet sind, die Operationen auszuführen, die im Falle einer Testanforderung darin bestehen, zu bestimmen, ob die Trennvorrichtung (DI) die Trennung gewährleisten kann, und, falls dies der Fall ist, diese Trennung anzuordnen und dann die Durchführung des Tests anzuordnen.

9. Fahrzeug (V), umfassend ein Bordnetz (RB), das von einer Servicebatterie (BS) und einem Konverter (CV) mit elektrischer Energie versorgt wird, eine Trennvorrichtung (DI), die die letzteren (BS, CV) voneinander trennen oder koppeln kann, und eine Testvorrichtung (DT), die einen Test der Servicebatterie (BS) durchführen kann, um eine Mindestspannung an den Anschlüssen der letzteren (BS) und einen Innenwiderstand der Servicebatterie (BS) zu bestimmen , **dadurch gekennzeichnet, dass** es außerdem eine Überwachungsvorrichtung (DS) gemäß Anspruch 8 umfasst.

10. Fahrzeug nach Anspruch 9, **dadurch gekennzeichnet, dass** es vom Typ eines Personenkraftwagens ist.

## Claims

1. Supervision method for a vehicle (V) comprising an on-board network (RB) supplied with electrical energy by a service battery (BS) and a converter (CV), an isolation device (DI) capable of isolating the latter (BS, CV) from each other or of coupling the latter (BS, CV), and a test device (DT) capable of carrying out a test of said service battery (BS) to determine a minimum voltage at the terminals of the latter (BS) and an internal resistance of said service battery (BS) , **characterized in that** it comprises a step (10-110) in which, in the event of a test request, it is determined whether said isolation device (DI) is capable of ensuring isolation, and if so, said isolation is ordered and then said test is ordered to be carried out.

2. Method according to claim 1, **characterized in that** in said step (10-110) it is also determined whether said test device (DT) is suitable for carrying out said test, and if so and when said isolation device (DI) is suitable for ensuring said isolation, the latter is ordered and then the carrying out of said test is ordered.

3. Method according to claim 2, **characterized in that** in said step (10-110), when said isolation device (DI) is suitable for ensuring said isolation and said test device (DT) is suitable for carrying out said test, it is determined whether said test device (DT) is already carrying out a test, and if not, said isolation is ordered and then said carrying out of the test is ordered.

4. Method according to one of claims 1 to 3, **characterized in that** in said step (10-110) , in the event of a need for coupling between said converter (CV) and service battery (BS) during the performance of said test, said coupling is ordered and an interruption of said test is ordered.

5. Method according to one of claims 1 to 4, **characterized in that** in said step (10-110) , at the end of carrying out said test, a state of said service battery (BS) is determined as a function of said minimum voltage and internal resistance determined, then reliability information of said test is determined as a function of at least said minimum voltage and internal resistance .

6. Method according to one of claims 1 to 5, **characterized in that** in said step (10-110) said test is carried out by causing at least two predefined current draws by said service battery (BS), during each of which a minimum intermediate voltage at the terminals of said service battery (BS) and an intermediate internal resistance of the latter (BS) are determined, and said minimum voltage is determined from said determined minimum intermediate voltages and said internal resistance from said determined intermediate internal resistances.

7. Computer program product comprising a set of instructions which, when executed by processing means, is capable of implementing the supervision method according to one of the preceding claims for supervising the performance of tests of a service battery (BS) equipping a vehicle (V) comprising an on-board network (RB) supplied with electrical energy by said service battery (BS) and a converter (CV), an isolation device (DI) capable of isolating the latter (BS, CV) from each other or of coupling the latter (BS, CV), and a test device (DT) capable of performing said tests of said service battery (BS) to determine a minimum voltage at the terminals of the latter (BS) and an internal resistance of said service battery (BS).

8. Supervision device (DS) for a vehicle (V) comprising an on-board network (RB) supplied with electrical energy by a service battery (BS) and a converter (CV), an isolation device (DI) capable of isolating the latter (BS, CV) from each other or of coupling the latter (BS, CV), and a test device (DT) capable of carrying out a test of said service battery (BS) to determine a minimum voltage at the terminals of the latter (BS) and an internal resistance of said service battery (BS) , **characterized in that** it comprises at least one processor (PR1) and at least one memory (MD) arranged to carry out the operations consisting, in the event of a test request, of determining whether said isolation device (DI) is capable of ensuring isolation, and if so, of ordering said isolation and then ordering the carrying out of said test.

9. Vehicle (V) comprising an on-board network (RB) supplied with electrical energy by a service battery (BS) and a converter (CV), an isolation device (DI) capable of isolating the latter (BS, CV) from each other or of coupling the latter (BS, CV), and a test device (DT) capable of carrying out a test of said service battery (BS) to determine a minimum voltage at the terminals of the latter (BS) and an internal resistance of said service battery (BS) , **characterized in that** it further comprises a supervision device (DS) according to claim 8.

10. Vehicle according to claim 9, **characterized in that** it is of the automobile type.
